# EUROPEAN PATENT APPLICATION

(11) **EP 3 771 918 A1**
(43) Date of publication of application: **03.02.2021**
(21) Application number: 19189130.8
(22) Date of filing: 30.07.2019
(51) Int. Cl.: G01R 33/385

(54) **NOISE REDUCTION IN MAGNETIC RESONANCE IMAGING**

(71) Applicant: Siemens Healthcare GmbH, 91052 Erlangen (DE)
(72) Inventor: ALSAN, Alper, 91054 Erlangen (DE); KIRMIZI-ALSAN, Elif, 91054 Erlangen (DE)

(57) **Abstract**

For generating data for noise reduction in MRI, an MRI machine (10) is operated according to a predefined MRI protocol. Sound generated by the MRI machine (10) during the operation is measured by a plurality of microphones (19). Anti-noise data is generated by a computing unit (18) coupled to the plurality of microphones (19) such that, when an array of loudspeakers (11) arranged in a predefined manner is controlled to reproduce the anti-noise data, an anti-noise sound field (14) results that attenuates a noise sound field within a predefined spatial region (9).

## Description

The present invention relates to a method for generating data for noise reduction in magnetic resonance imaging, to a method for noise reduction in magnetic resonance imaging, to a noise reduction system for magnetic resonance imaging, to a magnetic resonance imaging system, to an acquisition system for generating data for noise reduction in magnetic resonance imaging and to a computer program product.

Magnetic resonance imaging (hereafter denoted as MRI) systems produce high noise levels which may be hazardous for patients. Even events of hearing loss after MRI examinations have been reported, see for example "Case report: Sensorineural hearing loss after magnetic resonance imaging", A. Mollasadeghi et al., Case Rep Radiol., 2013, 510258.

Therefore, earplugs, headphones, earmuffs or memory foam pillows have been used to decrease the noise level generated by MRI pulse sequences.

However, such devices may be inconvenient for the patient and may be limited in effectivity. Furthermore, they also prevent the patient from hearing other sounds, for example a voice of an operator or music.

It is therefore an objective of the present invention to provide an improved concept for noise reduction in MRI providing higher effectivity and a higher level of comfort.

These objective is achieved by the respective subject matter of the independent claims. Further implementations and preferred embodiments are the subject matter of the dependent claims.

The improved concept is based on the idea to reproduce anti-noise by an array of loudspeakers to attenuate noise caused by the MRI machine in a predefined spatial region.

According to an independent aspect of the improved concept, a method for generating data for noise reduction in magnetic resonance imaging, MRI, is provided. For performing the method, an MRI machine is operated according to a predefined MRI protocol. Sound generated by the MRI machine during the operation is measured by a plurality of microphones, that is, in particular, by three or more microphones. Anti-noise data is generated, in particular generated and stored, by a computing unit coupled to the plurality of microphones, in particular coupled to each microphone of the plurality of microphones, based on the measured sound, in particular of the sound measured by all microphones of the plurality of microphones. Therein, the anti-noise data is generated such that, when an array of loudspeakers arranged in a predefined manner is controlled to reproduce the anti-noise data, an anti-noise sound field results that attenuates a noise sound field within a predefined spatial region. Therein, the noise sound field corresponds to the sound generated by the MRI machine during the operation according to the MRI protocol.

In particular, the method for generating data for noise reduction in MRI can be considered as a method for generating data for noise reduction when operating the MRI machine or another MRI machine or as a method for noise reduction for an MRI machine.

Measuring the sound by the microphones comprises, in particular, transducing or transforming the sound waves captured by the individual microphones into respective microphone signals. The microphone signals and/or microphone data depending on the microphone signals may be stored, in particular by means of the computing unit.

The array of loudspeakers being arranged in a predefined manner may for example be understood such that the individual loudspeakers of the array are arranged in a predefined manner with respect to each other and/or such that the whole array of loudspeakers is arranged at a predefined position and/or with a predefined orientation with respect to the MRI machine.

The array of loudspeakers comprises at least two loudspeakers, preferably five for more loudspeakers that are arranged for example at fixed positions with respect to each other. For example, the array may be a linear array of loudspeakers, that is, the individual loudspeakers of the array are arranged in a row or along a straight line. The array may also be a two-dimensional array, such that the loudspeakers of the array are arranged in a plane, for example in a regular manner. In other implementations, the loudspeakers may also be three-dimensionally arranged.

That the noise sound field corresponds to the sound generated by the MRI machine may be understood such that the sound generated by the MRI machine operating according to the MRI protocol or sound generated by a further MRI machine being operated according to the same MRI protocol cause a sound field equal to the noise sound field.

The predefined spatial region is in particular predefined with respect to the position and/or orientation of the array of loudspeakers.

In particular, the predefined spatial region may correspond to a region at or within the MRI machine, in particular a region for positioning a person, in particular a head of the person.

Attenuating the noise sound field may include reducing a sound pressure, noise level or noise field amplitude of the noise sound field within the predefined spatial area. Therein, the noise sound field may be completely suppressed or partly suppressed or reduced in the predefined spatial area.

In particular, for attenuating the noise sound field by the anti-noise sound field, the anti-noise data is reproduced synchronously with the operation of the MRI machine or the further MRI machine according to the MRI protocol.

The anti-noise data represents for example the data for noise reduction.

According to the improved concept, the data for noise reduction is provided and can be used during operation of an MRI machine at a later on. Therefore, the person to be examined by the MRI machine with its head positioned within the predefined spatial area experiences a reduced noise level due to the attenuation of the noise sound field by the anti-noise sound field. This leads to an improved level of comfort for the person, which may for example reduce health risks due that may be caused by high noise levels of regular MRI examinations without sufficient noise reduction.

Furthermore, the calmness of the person may be increased, which may result in a reduced level of movement of the person during the MRI operation and therefore to an improved quality of images generated by the MRI machine.

Furthermore, due to the individual correlation between the anti-noise sound field and the MRI protocol, and therefore effectively with the noise field, an improved noise reduction of noise may be achieved compared to conventional approaches.

Furthermore, since the person to be examined can go without earplugs, headphones or the like, it is able to hear other sounds such as for example music or a voice of an operator of the MRI machine.

The improved concept is based on the technique of wave field synthesis. In particular, reproducing the anti-noise data corresponds to a synthesis of the anti-noise sound field as a wave field according to wave field synthesis. In the particular case of the improved concept, wave field synthesis is exploited to achieve noise cancellation in the predefined spatial region.

According to several implementations of the method for generating data for noise reduction in MRI, the anti-noise data is stored by the computing unit to a storage device.

According to several implementations, the anti-noise data is generated by the computing unit based on a wave field synthesis technique, wherein the reproduction of the anti-noise data by the array of loudspeakers renders the anti-noise sound field as a sound field of a virtual sound source.

The technique of wave field synthesis is known to be able to generate synthetic sound fields that appear to be emitted by a virtual sound source. In case of the improved concept, the virtual sound source can be considered as an anti-noise sound source emitting exactly the anti-noise sound field that cancels, or partially cancels, the noise sound field within the spatial region.

The generation of the anti-noise data can therefore be considered as a reverse wave field synthesis or wave field analysis.

In particular, according wave field synthesis, any desired sound field may be generated. Therefore, in particular, the anti-noise sound field may be generated as necessary according to the actual geometric requirements and requirements of the MRI protocol under consideration, once the corresponding noise sound field is known. However, according to the improved concept, the noise sound field is actually know due to the measurement of the sound of the MRI machine being operated according to the MRI protocol.

For further details it is also referred to the publication "An approach to global noise control by wave field synthesis", A. Kuntz und R. Rabenstein, 12th European Signal Processing Conference IEEE 2004, Vienna, Austria. In particular, equation (2) of said publication describes the mathematical foundation of wave field synthesis.

Since the technique of wave field synthesis allows to generate arbitrary wave fields and therefore arbitrary anti-noise sound fields, the respective anti-noise data may be generated for any given MRI protocol, in particular may be generated in advance for a plurality of MRI protocols and provided in form of a database.

According to several implementations, the anti-noise data is stored, in particular by the computing unit, to a database, in particular on a storage device.

In such implementations, the method for generating data for noise reduction in MRI can be considered as a method for generating a database for noise reduction in MRI.

In particular, the database may be generated and provided before an operative use of a MRI machine according to the MRI protocol. Then, prior to performing the MRI examination, the anti-noise data corresponding to the respective MRI protocol to be used may be selected and the anti-noise sound field may be generated, as described.

According to several implementations, the method steps of operating the MRI machine according to the predefined MRI protocol, measuring the respective sound by the plurality of microphones, generating the anti-noise data and, if applicable, storing the anti-noise data to the database, may be repeated once or more than once for different predefined MRI protocols.

According to a further independent aspect of the improved concept, a method for noise reduction in MRI is provided. An MRI machine is operated according to a predefined MRI protocol. Anti-noise data for attenuating a noise sound field within a predefined spatial region is provided, in particular provided depending on the MRI protocol, for example provided on a storage device. Therein, the noise sound field corresponds to sound generated by the MRI machine during the operation according to the MRI protocol. An array of loudspeakers arranged in a predefined manner, in particular with respect to themselves and/or with respect to the MRI machine, is controlled by a control unit to reproduce the anti-noise data synchronously with respect to the operation of the MRI machine according to the MRI protocol.

Controlling the array of loudspeakers to reproduce the anti-noise data corresponds to controlling the array of loudspeakers to replay one or more corresponding sound files storing the anti-noise data.

In particular, the control unit is configured to control each loudspeaker of the array of loudspeakers individually depending on the anti-noise data. That is, in particular, the individual loudspeakers of the array of loudspeakers do in general not produce the same sound waves.

For the advantages of the method for noise reduction in MRI it is referred to the advantages of the method for generating data for noise reduction in MRI according to the improved concept explained above.

According to several implementations of the method for noise reduction in MRI, providing the anti-noise data comprises providing the anti-noise data in a database and selecting, in particular by means of the control unit, the anti-noise data according to the MRI protocol from the database.

According to several implementations, controlling the array of loudspeakers causes the array of loudspeakers to generate the anti-noise sound field with one or more planar wave fronts or respective plane waves, and with one or more concave or focused wave fronts. Therein, the concave or focused wave fronts are directed towards a focus point within the predefined spatial area.

In such implementations, the sound waves of the anti-noise sound field may be precisely targeted towards the predefined spatial area, in particular towards the person to be examined and its head, such that the noise reduction is particularly effective.

According to several implementations, an anti-noise sound field is generated by the reproduction of the anti-noise data, the anti-noise sound field attenuating the noise sound field within the predefined spatial area. In particular, the anti-noise data is generated such that the anti-noise sound field resulting when reproducing the anti-noise data by the array of loudspeakers attenuates the noise sound field within the predefined spatial region.

According to several implementations, the array of loudspeakers is controlled to reproduce the anti-noise data according to a wave field synthesis technique to render the anti-noise sound field as a sound field of a virtual sound source.

According to several implementations, additional sound data is provided, wherein the additional sound data is independent of the anti-noise data. The array of loudspeakers is controlled by the control unit to reproduce the additional sound data and the anti-noise sound data simultaneously.

The additional sound data may for example be provided on the storage device or by a further microphone, wherein an additional loudspeaker or an operator may provide input to the further microphone.

The additional sound data being independent of the anti-noise data means, in particular, that the additional sound data is not required and not intended for attenuating the noise sound field.

For example, the additional sound data may correspond to ambient sound, music or a voice of the operator or the like. The additional sound is therefore provided to the predefined spatial area and in particular to the person to be examined. Therefore, information can be provided to the person or the patient can be provided with relaxing sound to increase calmness of the person.

Additional sound data may for example give rise to an additional sound field corresponding to a sound field of a further virtual sound source, in particular since the additional sound field may be generated based on wave field synthesis as well. Therefore, the person can for example experience a feeling of proximity of the virtual sound source, for example the operator, even though the actual sound source, for example the operator or loudspeaker, may be situated remotely, for example in a control room. Due to the increased calmness of the person, results of the MRI examinations may be improved.

According to several implementations, the anti-noise data is or was generated according to a method for generating data for noise reduction in MRI according to the improved concept.

In some implementations, the anti-noise data are generated in the course of the method for noise reduction according to the improved concept. That is, the method steps of the method for generating data for noise reduction in MRI are part of the method for noise reduction in MRI.

In other implementations, the method for noise reduction in MRI does not comprise the method steps of the method for generating data for noise reduction in MRI.

According to a further independent aspect of the improved concept, a noise reduction system for MRI is provided. The noise reduction system comprises a storage device storing anti-noise data for attenuating a noise sound field within a predefined spatial region, wherein the noise sound field corresponds to sound generated by an MRI machine during an operation of the MRI machine according to a predefined MRI protocol. The noise reduction system comprises an array of loudspeakers arranged in a predefined manner and a control unit configured to control the array of loudspeakers to reproduce the anti-noise data synchronously with respect to the operation of the MRI machine according to the MRI protocol.

In particular, the storage device may store a database comprising the anti-noise data. The database may in particular comprise further anti-noise data sets corresponding to further MRI protocols.

According to several implementations, the noise reduction system comprises a wave field synthesis system comprising the array of loudspeakers and the control unit. The wave field synthesis system is configured to generate an anti-noise sound field by reproducing the anti-noise data, the anti-noise sound field attenuating the noise sound field within the predefined spatial region.

The wave field synthesis system being configured to generate the anti-noise sound field means, in particular, that the control unit is configured to control the array of loudspeakers correspondingly.

Furthermore, the loudspeakers of the array of loudspeakers is, in particular, arranged accordingly with respect to each other and/or with respect to the MRI machine to cause the attenuation of the noise sound field by the anti-noise sound filed in the predefined spatial region.

According to several implementations of the noise reduction system, the anti-noise data was generated according to a method for generating data for noise reduction in MRI according to the improved concept.

In particular, the storage device stores the database, wherein the database is generated according to a method for generating a database for noise reduction in MRI according to the improved concept.

Further implementations for the noise reduction system according to the improved concept follow directly from the various implementations of the method for noise reduction in MRI according to the improved concept and vice versa. In particular, the noise reduction system according to the improved concept may be configured or programmed to perform a method for noise reduction according to the improved concept or the noise reduction system performs a method for noise reduction according to the improved concept.

According to a further independent aspect of the improved concept, an MRI system comprising an MRI machine is provided. The MRI system further comprises a noise reduction system according to the improved concept.

According to several implementations of the MRI system, the array of loudspeakers is arranged with respect to the MRI machine, such that the predefined spatial region includes a region of the MRI machine for placing a head of a person to be examined by the MRI machine.

According to a further independent aspect of the improved concept, an acquisition system for generating data for noise reduction in MRI is provided. The acquisition system comprises an MRI machine and a further control unit, the further control unit configured to operate the MRI machine according to a predefined MRI protocol. The acquisition system comprises a plurality of microphones, configured and arranged to measure sound generated by the magnetic resonance imaging machine during the operation of the MRI machine according to the MRI protocol. The acquisition system comprises a computing unit coupled to the plurality of microphones and configured to generate anti-noise data based on the measured sound, such that, when an array of loudspeakers arranged in a predefined manner is controlled to reproduce the anti-noise data, an anti-noise sound field results that attenuates a noise sound field within a predefined spatial region, wherein the noise sound field corresponds to the sound generated by the MRI machine during the operation of the MRI machine according to the MRI protocol.

Further implementations of the acquisition system follow directly from the various implementations of the method for generating data for noise reduction for MRI according to the improved concept and vice versa. In particular, the acquisition system may be configured or programmed to perform a method for generating data for noise reduction according to the improved concept or the acquisition system performs such a method.

According to a further independent aspect of the improved concept, a first computer program comprising first instructions is provided. When the first computer program is executed by a noise reduction system according to the improved concept, the first instructions cause the noise reduction system to carry out a method for noise reduction in MRI according to the improved concept.

According to a further independent aspect of the improved concept, a second computer program comprising second instructions is provided. When the second computer program is executed by an acquisition system according to the improved concept, the second instructions cause the acquisition system to carry out a method for generating data for noise reduction in MRI according to the improved concept.

The first and the second computer program may for example be considered as computer program products.

According to a further independent aspect of the improved concept, a computer-readable storage medium is provided, the computer-readable storage medium storing a first computer program and/or a second computer program according to the improved concept.

The computer-readable storage medium may be considered as a computer program product.

The features and feature combinations mentioned above or below in the description of figures and/or shown in the figures alone are usable not only in the respective specified combinations, but also in other combinations without departing from the scope of the invention. Implementations and feature combinations, which do not have all features of an originally formulated independent claim and/or extend beyond or deviate from the feature combinations set out in the relations of the claims, are also to be considered as disclosed.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures:
- FIG 1: shows a schematic representation of an exemplary implementation of an MRI system according to the improved concept;
- FIG 2: a flow diagram of an exemplary implementation of a method for generating data for noise reduction in MRI and a corresponding method for noise reduction in MRI.

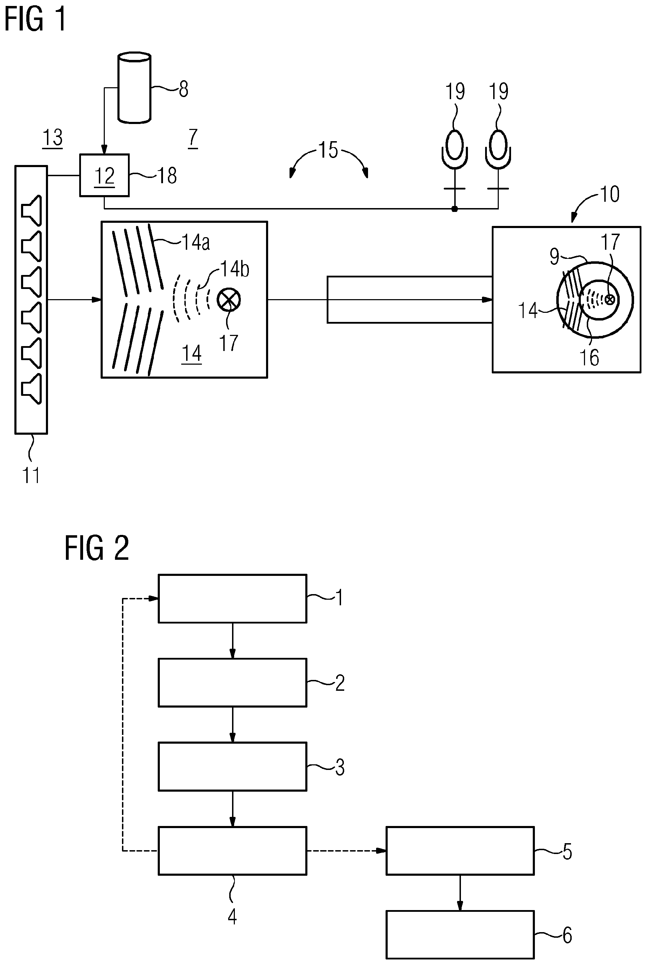

In FIG 1, an MRI system 15 is schematically shown, the MRI system 15 comprising an MRI machine 10 and a noise reduction system 7 according to the improved concept.

The noise reduction system 7 comprises a storage device 8 and a wave field synthesis system 13 with a control unit 12 and array of loudspeakers 11.

The control unit 12 is coupled to the storage device 8, in particular for reading data from the storage device 8. The control unit 12 is also coupled to the array of loudspeakers 11, in particular for controlling the array of loudspeakers 11.

The MRI machine 10 comprises a predefined spatial region 9 for placing a head 16 of a person to be examined by means of the MRI machine 10.

The storage device 8 comprises a database storing a plurality of anti-noise data sets, wherein each anti-noise data set is associated to a corresponding predefined MRI protocol.

The person is to be examined according to a given MRI protocol. The control unit 12 or an operator of the MRI system 15 may select a corresponding anti-noise data set from the database of the storage device 8. The control unit 12 controls the array of loudspeakers 11 to reproduce the anti-noise data set.

At the same time, the MRI machine 10 is operated according to the MRI protocol.

Due to the operation of the MRI machine 10 it generates sound or noise, in particular a noise sound field within the region 9.

The control unit 12 is configured to reproduce the anti-noise data set synchronously with the MRI protocol.

By reproducing the anti-noise data set, an anti-noise sound field 14 is generated. In particular, a specific combination of plane waves 14a and focused or concave waves 14b is generated based of wave field synthesis to generate the anti-noise sound field 14. In particular, the focused waves are directed towards a focus point 17, which corresponds for example to a nominal position for the head 16 of the person. The anti-noise data set is generated such that the anti-noise sound field 14 attenuates the noise sound field within the region 9 at least partially, such that a level of noise for the person is reduced compared to the sole noise field. Therefore, the array of loudspeakers 11 is, for example, arranged in a predefined manner with respect to the MRI machine 10, in particular has a predefined position and/or orientation with respect to the MRI machine 10.

The functionality of the MRI system 15 and the noise reduction system 7, respectively, is explained in more detail with respect to exemplary implementations of a method for generating data for noise reduction and for noise reduction in MRI according to the improved concept, as depicted schematically in FIG 2.

FIG 2 shows a flow diagram of an exemplary implementation of a method for noise reduction in MRI according to the improved concept, wherein steps 1 to 4 correspond to a method for generating data for noise reduction in MRI.

In particular, steps 1 to 4 of the method are carried out by means of an acquisition system for generating data for noise reduction in MRI according to the improved concept. The noise reduction system 13 of FIG 1 can also be considered as such acquisition system. In this case, the noise reduction system 15 further comprises a plurality of microphones 19 arranged to measure sound generated by the MRI machine 10 when operated according to one of the plurality of predefined MRI protocols. Furthermore, the noise reduction system 13 comprises a computing unit 18, wherein the control unit 12 may or may not be part of the computing unit 18.

In particular, the computing unit 18 is coupled to the plurality of microphones 19 to receive respective microphone signals and is coupled to the storage device 8 or a further storage device (not shown).

In general, however, the acquisition system may be different from the noise reduction system 13.

In step 1 of the method, the MRI machine 10 is operated, for example by the control unit 12, the computing unit 18 or a further control unit (not shown) of the noise reduction system 15, according to a predefined given MRI protocol. In step 2 of the method, the plurality of microphones 19 measure the sound generated by the MRI machine 10 during the operation. In particular, each of the microphones 19 creates a respective microphone signal based on the measured sound and provides it to the computing unit 18.

In step 3 of the method, the computing unit 18 receives the microphone signals and generates the anti-noise data based on the measured sound, in particular based on the microphone signals.

To achieve this, the computing unit 18 uses the technique of wave field synthesis or, in particular, a reverse wave field synthesis or wave field analysis to generate the anti-noise data. In particular, the anti-noise data are generated in a purposive manner to achieve the desired goal, namely that, when the anti-noise data are reproduced by the array of loudspeakers 11, the corresponding anti-noise sound field 14 attenuates the noise field within the spatial region 9.

To this end, the computing unit 18 computes, in particular, a specific superposition of sound waves, in particular plane sound waves and focused or concave sound waves directed towards the focus point 17, to construct the anti-noise data accordingly.

In step 4 of the method, the computing unit 18 stores the anti-noise data for example on the storage device 8.

As indicated in FIG 2, steps 1 to 4 of the method may be repeated for different MRI protocols, such that a database of the storage device 8 can be filled with a plurality of anti-noise data sets corresponding to the different MRI protocols.

In step 5 of the method one of the MRI protocols is selected to be carried out for examining a person by means of the MRI machine 10, wherein the head of the person 17 is located within the spatial region 9.

Then, the control unit 12 selects the corresponding anti-noise data from the database of the storage device 8 and the MRI machine 10 is operated, for example by the further control unit, according to the selected MRI protocol.

In step 6, the control unit 12 controls the array of loudspeakers 11 synchronously with respect to the operation of the MRI machine 10 to generate the anti-noise sound field 14 by reproducing the anti-noise data corresponding to the selected MRI protocol.

Therefore, the anti-noise sound field 14 and the noise sound field superpose within the spatial region 9 to attenuate the noise sound field at least partially, in particular by at least partial destructive interference of sound waves.

As explained, by means of the improved concept, noise reduction in MRI may be improved, in particular to provide a higher level of comfort for persons to be examined and an improved noise suppression by generating three-dimensional anti-noise sound fields by means of an active noise cancelling system based on a library or database of anti-noise data of the most typical MRI protocols, which may be recorded with multiple microphones. The wave field synthesis system delivers the three-dimensional anti-noise sound field to the region around the person's head. In this way, a "silent bubble" is generated around the person's head.

In particular, the performance of the sound attenuation is increased by means of the improved concept, because the anti-noise may be controlled in a precise and accurate way by individual control of the loudspeakers. Especially planar waves enable the creation of confined sound fields, constant volume over distance and control over sound wave propagation.

The improved concept enables also the operator to talk directly to the person being examined via the wave field synthesis system, which may give generate a feeling of proximity for the person, as if the operator was close to the person. This may increase calmness of the person and therefore the quality of examination results.

## Claims

1. Method for generating data for noise reduction in magnetic resonance imaging,
**characterized in that**
a magnetic resonance imaging machine (10) is operated according to a predefined magnetic resonance imaging protocol;
sound generated by the magnetic resonance imaging machine (10) during the operation is measured by a plurality of microphones (19);
anti-noise data is generated by a computing unit (18) coupled to the plurality of microphones (19) based on the measured sound;
the anti-noise data is generated such that, when an array of loudspeakers (11) arranged in a predefined manner is controlled to reproduce the anti-noise data, an anti-noise sound field (14) results that attenuates a noise sound field within a predefined spatial region (9); and
the noise sound field corresponds to the sound generated by the magnetic resonance imaging machine during the operation.

2. Method according to claim 1,
**characterized in that**
the anti-noise data is generated by the computing unit (18) based on a wave field synthesis technique, wherein the reproduction of the anti-noise data by the array of loudspeakers (11) renders the anti-noise sound field (14) as a sound field of a virtual sound source.

3. Method according to one of claims 1 or 2,
**characterized in that**
the anti-noise data is stored to a database (8).

4. Method for noise reduction in magnetic resonance imaging, wherein a magnetic resonance imaging machine (10) is operated according to a predefined magnetic resonance imaging protocol;
**characterized in that**
anti-noise data for attenuating a noise sound field within a predefined spatial region (9) is provided, wherein the noise sound field corresponds to sound generated by the magnetic resonance imaging machine (10) during the operation;
an array of loudspeakers (11) arranged in a predefined manner is controlled by a control unit (12) to reproduce the anti-noise data synchronously with respect to the operation.

5. Method according to claim 4,
**characterized in that**
an anti-noise sound field (14) is generated by the reproduction of the anti-noise data, the anti-noise sound field (14) attenuating the noise sound field within the predefined spatial region (9).

6. Method according to claim 5,
**characterized in that**
the array of loudspeakers (11) is controlled to reproduce the anti-noise data according to a wave field synthesis technique to render the anti-noise sound field (14) as a sound field of a virtual sound source.

7. Method according to one of claims 4 to 6,
**characterized in that**
additional sound data is provided, wherein the additional sound data is independent of the anti-noise data;
the array of loudspeakers (11) is controlled by the control unit (12) to reproduce the additional sound data and the anti-noise sound data simultaneously.

8. Method according to one of claims 4 to 7,
**characterized in that**
the anti-noise data is or was generated according to a method for generating data for noise reduction in magnetic resonance imaging of one of claims 1 to 3.

9. Noise reduction system for magnetic resonance imaging,
**characterized in that**
the noise reduction system (7) comprises a storage device (8) storing anti-noise data for attenuating a noise sound field within a predefined spatial region (9), wherein the noise sound field corresponds to sound generated by a magnetic resonance imaging machine (10) during an operation according to a predefined magnetic resonance imaging protocol;
the noise reduction system (7) comprises an array of loudspeakers (11) arranged in a predefined manner; and
the noise reduction system (7) comprises a control unit (12) configured to control the array of loudspeakers (11) to reproduce the anti-noise data synchronously with respect to the operation.

10. Noise reduction system according to claim 9,
**characterized in that**
the noise reduction system (7) comprises a wave field synthesis system (13) comprising the array of loudspeakers (11) and the control unit (12); and
the wave field synthesis system (13) is configured to generate an anti-noise sound field (14) by reproducing the anti-noise data, wherein the anti-noise sound field (14) attenuates the noise sound field within the predefined spatial region (9) .

11. Noise reduction system according to one of claims 9 or 10,
**characterized in that**
the anti-noise data was generated according to a method for generating data for noise reduction in magnetic resonance imaging of one of claims 1 to 3.

12. Magnetic resonance imaging system comprising a magnetic resonance imaging machine (10),
**characterized in that**
the magnetic resonance imaging system (15) comprises a noise reduction system (7) according to one of claims 9 to 11.

13. Magnetic resonance imaging system according to claim 12,
**characterized in that**
the array of loudspeakers (11) is arranged with respect to the magnetic resonance imaging machine (10), such that the predefined spatial region (9) includes a region of the magnetic resonance imaging machine (10) for placing a head (16) of a person to be examined.

14. Acquisition system for generating data for noise reduction in magnetic resonance imaging,
**characterized in that**
the acquisition system (15) comprises a magnetic resonance imaging machine (10) and a further control unit, configured to operate the magnetic resonance imaging machine (10) according to a predefined magnetic resonance imaging protocol; the acquisition system (15) comprises a plurality of microphones (19), configured and arranged to measure sound generated by the magnetic resonance imaging machine (10) during the operation; and
the acquisition system (15) comprises a computing unit (18) coupled to the plurality of microphones (19) and configured to generate anti-noise data based on the measured sound, such that, when an array of loudspeakers (11) arranged in a predefined manner is controlled to reproduce the anti-noise data, an anti-noise sound field (14) results that attenuates a noise sound field within a predefined spatial region (9), wherein the noise sound field corresponds to the sound generated by the magnetic resonance imaging machine (10) during the operation.

15. Computer program product comprising
first instructions that, when executed by a noise reduction system according to one of claims 9 to 11, cause the noise reduction system to carry out a method according to one of claims 4 to 8; and/or
second instructions that, when executed by an acquisition system according to claim 14, cause the acquisition system to carry out a method according to one of claims 1 to 3.
